# EUROPEAN PATENT APPLICATION

(11) **EP 4 818 714 A1**
(43) Date of publication of application: **07.10.2026**
(21) Application number: 24895692.2
(22) Date of filing: 29.07.2024
(51) Int. Cl.: G01R 31/36, G01R 31/385, G01R 19/25

(54) **SIGNAL SAMPLING CIRCUIT, BATTERY MANAGEMENT SYSTEM, BATTERY SYSTEM AND ELECTRIC APPARATUS**

(30) Priority: 30.11.2023 CN 202323277335 U
(71) Applicant: Contemporary Amperex Technology Co., Limited, Ningde, Fujian 352100 (CN)
(72) Inventor: GUO, Maobo, Ningde, Fujian 352100 (CN); LI, Qiandeng, Ningde, Fujian 352100 (CN); LIU, Jingjiang, Ningde, Fujian 352100 (CN); YE, Fuming, Ningde, Fujian 352100 (CN); LI, Weiqiang, Ningde, Fujian 352100 (CN)
(74) Representative: Lorenz Seidler Gossel Part. mbB
(86) International application number: PCT/CN2024/108051
(87) International publication number: WO 2025/112589

(57) **Abstract**

Disclosed in the present application are a signal sampling circuit, a battery management system, a battery system and an electric apparatus. The signal sampling circuit comprises a voltage dividing module, a switch module and a sampling module, wherein the voltage dividing module and the switch module are connected in series between a point to be measured and a reference signal end of the sampling module, a control end of the switch module is connected to an enabling signal end of the sampling module, and the sampling module is connected to a first reference ground; and a sampling point is provided in the voltage dividing module, and the sampling module is configured to collect a sampling signal of the sampling point. According to the embodiments of the present application, a reduction in the cost of a signal sampling circuit is facilitated.

## Description

### CROSS-REFERENCE TO RELATED APPLICATIONS

The present application claims priority to Chinese Patent Application No. 202323277335.1, entitled "SIGNAL SAMPLING CIRCUIT, BATTERY MANAGEMENT SYSTEM, BATTERY SYSTEM, AND POWER CONSUMING APPARATUS" and filed on November 30, 2023, which is incorporated herein by reference in its entirety.

### TECHNICAL FIELD

The present application relates to the field of battery technologies, and in particular, to a signal sampling circuit, a battery management system, a battery system, and a power consuming apparatus.

### BACKGROUND

With the continuous development of battery technologies, users' demands for batteries are increasing.

In the related technology, a signal sampling circuit is provided to sample a to-be-tested point. However, the signal sampling circuit in the related technology has a problem of high cost.

### SUMMARY

Embodiments of the present application provide a signal sampling circuit, a battery management system, a battery system, and a power consuming apparatus, helping reduce costs of the signal sampling circuit.

According to a first aspect, the present application provides a signal sampling circuit, including a voltage division module, a switching module, and a sampling module.

The voltage division module and the switching module are connected in series between a to-be-tested point and a reference signal end of the sampling module. A control end of the switching module is connected to an enable signal end of the sampling module. The sampling module is connected to a first reference ground.

A sampling point is provided in the voltage division module. The sampling module is configured to acquire a sampling signal of the sampling point.

In this embodiment of the present application, the voltage division module and the switching module are connected in series between the to-be-tested point and the reference signal end of the sampling module. The control end of the switching module is connected to the enable signal end of the sampling module. The sampling module is connected to the first reference ground. In a case that the to-be-tested point is a high-voltage to-be-tested point, the first reference ground may be a high-voltage ground, and the sampling module is connected to the high-voltage ground. Therefore, the sampling module is at a high-voltage side, so that the control end and a controlled end of the switching module are both located at the high-voltage side. Therefore, compared with a highly insulated and voltage-resistant device, the control end and the controlled end of the switching module help reduce costs of the signal sampling circuit.

In an optional implementation of the first aspect, the signal sampling circuit further includes a one-way turn-on module. The one-way turn-on module, the switching module, and the voltage division module are connected in series between the to-be-tested point and a signal acquisition end of the sampling module. The one-way turn-on module is configured to control a current to flow from the to-be-tested point to the sampling module. In this way, the one-way turn-on module connected in series to the switching module and the voltage division module is provided to control the current to flow from the to-be-tested point to the sampling module, thereby reducing a risk of a potential loop in the signal sampling circuit when the switching module is turned off.

In an optional implementation of the first aspect, the voltage division module includes a first resistor and a second resistor. The first resistor and the second resistor are connected in series. The sampling point is provided between the first resistor and the second resistor. In this way, the first resistor and the second resistor connected in series to the first resistor are provided, and the sampling point is provided between the first resistor and the second resistor. Thus, the voltage value of the to-be-tested point may be calculated according to the sampling signal acquired by the sampling module at the sampling point and voltage division resistance of the second resistor. In addition, a diode is provided in the one-way turn-on module to control the current to flow from the to-be-tested point to the sampling module, thereby reducing a risk of a potential loop in the signal sampling circuit.

In an optional implementation of the first aspect, the signal sampling circuit further includes a level conversion module. The level conversion module is connected between the enable signal end and the control end of the switching module. The level conversion module is configured to perform level conversion on a control signal of the enable signal end, and provide a level-converted control signal to the control end of the switching module. In this way, the level conversion module connected between the enable signal end and the control end of the switching module is provided. In a case that the control signal of the sampling module does not satisfy a start condition for driving the switching module and is insufficient for driving the switching module, the level conversion module provides the level-converted control signal to the switching module, helping drive the switching module to be turned on or off.

In an optional implementation of the first aspect, the level conversion module includes a first switching submodule and a second switching submodule. A control end of the first switching submodule is connected to the enable signal end. A first end of the first switching submodule is connected to the first reference ground. A second end of the first switching submodule is connected to a control end of the second switching submodule. A first end of the second switching submodule is connected to a high-voltage power supply end. A second end of the second switching submodule is connected to the first reference ground and the control end of the switching module. The first switching submodule is configured to be turned on or off under the control of the control signal. The second switching submodule is configured to be turned on or off under the control of the first switching submodule, to perform level conversion on the control signal and provide the converted control signal to the control end of the switching module. In this way, the first switching submodule connected to the enable signal end and the second switching submodule connected to the second end of the first switching submodule are provided. The first switching submodule may be turned on or off in a case that the enable signal end provides the control signal, and the second switching submodule may be further controlled to be turned on or off, thereby performing level conversion on the control signal, to provide the level-converted control signal to the switching module in a case that the control signal of the sampling module does not satisfy the start condition for driving the switching module and is insufficient for driving the switching module, helping drive the switching module to be turned on or off.

In an optional implementation of the first aspect, the level conversion module further includes a third switching submodule. A control end of the third switching submodule is connected to the second end of the first switching submodule. A first end of the third switching submodule is connected to the second end of the second switching submodule. A second end of the third switching submodule is connected to the first reference ground. The third switching submodule is configured to be turned on or off under the control of the first switching submodule, to perform level conversion on the control signal and provide the converted control signal to the control end of the switching module. In this way, the control end of the third switching submodule is connected to the second end of the first switching submodule. The first switching submodule may be turned off in a case that the enable signal end provides a non-enable signal, and the third switching submodule may be further controlled to be turned off, thereby providing the level-converted non-enable signal to the switching module in a case that the non-enable signal of the sampling module does not satisfy the start condition for driving the switching module and is insufficient for driving the switching module to be turned off, helping drive the switching module to be turned off.

In an optional implementation of the first aspect, the level conversion module further includes a current limiting submodule. The current limiting submodule is connected between the control end of the switching module and the second end of the second switching submodule. And/or, the level conversion module further includes a resetting submodule. The resetting submodule is connected between the control end of the switching module and the first reference ground. The resetting submodule is configured to reset the control end of the switching module. In this way, the current limiting submodule is provided in the level conversion module, to reduce the current between the control end of the switching module and the second end of the second switching submodule, thereby helping protect the control end of the switching module and the second end of the second switching submodule. In addition, the resetting submodule is provided in the level conversion module, facilitating resetting of the control end of the switching module.

In an optional implementation of the first aspect, the current limiting submodule includes a third resistor. And/or, the resetting submodule includes a fourth resistor. In this way, the current limiting submodule is provided with the third resistor, to reduce the current between the control end of the switching module and the second end of the second switching submodule, thereby helping protect the control end of the switching module and the second end of the second switching submodule. In addition, the resetting submodule is provided with the fourth resistor, facilitating resetting of the control end of the switching module.

In an optional implementation of the first aspect, the level conversion module further includes a current limiting submodule. The current limiting submodule is connected between the control end of the switching module and the second end of the second switching submodule. In this way, the current limiting submodule is provided in the level conversion module, to reduce the current between the control end of the switching module and the second end of the second switching submodule, thereby helping protect the control end of the switching module and the second end of the second switching submodule.

In an optional implementation of the first aspect, the current limiting submodule includes a third resistor. In this way, the current limiting submodule is provided with the third resistor, to reduce the current between the control end of the switching module and the second end of the second switching submodule, thereby helping protect the control end of the switching module and the second end of the second switching submodule.

In an optional implementation of the first aspect, the first switching submodule, the second switching submodule, and the third switching submodule each include a transistor. In this way, the first switching submodule, the second switching submodule, and the third switching submodule are each provided with the transistor. Then, by controlling the transistors to be turned on or off, the level-converted control signal is provided to the switching module in a case that the control signal of the sampling module does not satisfy the start condition for driving the switching module and is insufficient for driving the switching module to be turned off, helping drive the switching module to be turned on or off.

In an optional implementation of the first aspect, the level conversion module further includes a first voltage division submodule. The first voltage division submodule is connected between the high-voltage power supply end and the second end of the first switching submodule, and a voltage division node of the first voltage division submodule is connected to the control end of the second switching submodule. And/or, the level conversion module further includes a second voltage division submodule. The second voltage division submodule is connected to the enable signal end and the first reference ground, and a voltage division node of the second voltage division submodule is connected to the control end of the first switching submodule. In this way, the first voltage division submodule is provided between the high-voltage power supply end and the second end of the first switching submodule, and the voltage division node of the first voltage division submodule is connected to the control end of the second switching submodule, helping reduce a voltage at the control end of the second switching submodule, thereby helping protect the second switching submodule. In addition, the second voltage division submodule is provided between the enable signal end and the first reference ground, and the voltage division node of the second voltage division submodule is connected to the control end of the first switching submodule, helping reduce a voltage at the control end of the first switching submodule, thereby helping protect the first switching submodule.

In an optional implementation of the first aspect, the first voltage division submodule includes a fifth resistor and a sixth resistor. The fifth resistor and the sixth resistor are connected in series. The voltage division node of the first voltage division submodule is provided between the fifth resistor and the sixth resistor. And/or, the second voltage division submodule includes a seventh resistor and an eighth resistor. The seventh resistor and the eighth resistor are connected in series. The voltage division node of the second voltage division submodule is provided between the seventh resistor and the eighth resistor. In this way, the fifth resistor and the sixth resistor connected in series are provided in the first voltage division submodule, helping reduce the voltage at the control end of the second switching submodule by means of voltage division between the fifth resistor and the sixth resistor, thereby helping protect the second switching submodule. In addition, the magnitude of the voltage at the control end of the second switching submodule may be flexibly controlled by controlling a resistance value between the fifth resistor and the sixth resistor. In addition, the seventh resistor and the eighth resistor connected in series are provided in the second voltage division submodule, helping reduce the voltage at the control end of the first switching submodule by means of voltage division between the seventh resistor and the eighth resistor, thereby helping protect the first switching submodule. In addition, the magnitude of the voltage at the control end of the first switching submodule may be flexibly controlled by controlling a resistance value between the seventh resistor and the eighth resistor.

Based on a same inventive concept, according to a second aspect, an embodiment of the present application further provides a battery management system. The battery management system includes:
a controller;
an isolated communication module;
and a signal sampling circuit according to any implementation of the first aspect. A sampling module in the signal sampling circuit is connected to the controller by using the isolated communication module.

The controller is configured to:
send a sampling instruction to the sampling module by using the isolated communication module, where the sampling instruction is configured for instructing the sampling module to acquire a sampling signal and transmitting the sampling signal to the controller by using the isolated communication module; and
receive the sampling signal.

In this embodiment of the present application, the controller sends the sampling instruction to the sampling module by using the isolated communication module, so that the sampling module acquires the sampling signal, transmits the sampling signal to the controller by using the isolated communication module, and receives the sampling signal, thereby helping calculate the voltage of a to-be-tested point by the controller according to the sampling signal.

In an optional implementation of the second aspect, the sampling module further includes a one-way turn-on module. The one-way turn-on module includes a diode. The controller is further configured to:
obtain a voltage drop value of the diode at a target temperature and an initial voltage value of a to-be-tested point at the target temperature, where the initial voltage value is obtained through calculation according to the sampling signal; and
calibrate the initial voltage value by using the voltage drop value.

In this way, the controller obtains the voltage drop value of the diode at the target temperature and the initial voltage value of the to-be-tested point at the target temperature, and then may calibrate the initial voltage value by using the voltage drop value, to improve a problem that an impact of temperature on voltage drop of the diode causes an error in the determined voltage of the to-be-tested point, thereby improving accuracy of the voltage of the to-be-tested point.

Based on a same inventive concept, according to a third aspect, an embodiment of the present application further provides a battery system, including a battery and a battery management system according to any implementation of the second aspect.

Based on a same inventive concept, according to a fourth aspect, an embodiment of the present application further provides a power consuming apparatus, including a battery management system according to any implementation of the second aspect.

The above descriptions only refer to an overview of the technical solution of the present application. To understand the technical means of the present application more clearly, it may be implemented according to the content of the descriptions. To make the foregoing and other objectives, features and advantages of the present application more apparent, specific implementations of the present application are listed below.

### BRIEF DESCRIPTION OF THE DRAWINGS

In the following, the features, advantages, and technical effects of exemplary embodiments of the present application are described with reference to the accompanying drawings.
FIG. 1 is a schematic diagram of a structure of a signal sampling circuit according to an embodiment of the present application;
FIG. 2 is a schematic diagram of a structure of a signal sampling circuit according to another embodiment of the present application;
FIG. 3 is a schematic diagram of a structure of a signal sampling circuit according to still another embodiment of the present application;
FIG. 4 is a schematic diagram of a structure of a signal sampling circuit according to still another embodiment of the present application;
FIG. 5 is a schematic diagram of a structure of a signal sampling circuit according to still another embodiment of the present application;
FIG. 6 is a schematic diagram of a structure of a signal sampling circuit according to still another embodiment of the present application;
FIG. 7 is a schematic diagram of a structure of a level conversion module in a signal sampling circuit according to an embodiment of the present application;
FIG. 8 is a schematic diagram of a structure of another level conversion module in a signal sampling circuit according to another embodiment of the present application;
FIG. 9 is a schematic diagram of a structure of a battery management system according to an embodiment of the present application;
FIG. 10 is a schematic diagram of a structure of a battery system according to an embodiment of the present application; and
FIG. 11 is a schematic diagram of a structure of a power consuming apparatus according to an embodiment of the present application.

### Reference Numerals:

10: signal sampling circuit; 11: voltage division module; 12: switching module; 13: sampling module; 14: one-way turn-on module; 15: level conversion module; 151: first switching submodule; 152: second switching submodule; 153: third switching submodule; 154: current limiting submodule; 155: resetting submodule; 156: first voltage division submodule; 157: second voltage division submodule; 16: positive switching module; 20: isolated communication module; 30: controller; 100: battery management system; 200: battery; 1000: battery system; 2000: power consuming apparatus;
S: sampling point; EN2: enable signal end; HV-GND: first reference ground; LV-GND: second reference ground; HV1: to-be-tested point; Vref: reference signal end; V1: signal acquisition end; VCC: high-voltage power supply end.

### DETAILED DESCRIPTION

To make the objectives, technical solutions, and advantages of embodiments of the present application clearer, the following clearly and completely describes the technical solutions in the embodiments of the present application with reference to the accompanying drawings in the embodiments of the present application. Apparently, the described embodiments are merely some rather than all of the embodiments of the present application. All other embodiments obtained by a person of ordinary skill in the art based on the embodiments of the present application without making creative efforts shall fall within the protection scope of the present application.

Unless otherwise defined, all technical and scientific terms used in the present application have same meanings as commonly understood by a person skilled in the technical field of the present application. The terms used in the specification of the present application are merely for an objective of describing specific examples, and are not intended to limit the present application. The terms "include", "have" and any variations thereof in the specification and claims of the present application and in the foregoing descriptions of the accompanying drawings are intended to cover non-exclusive inclusion. In the specification, claims, or accompanying drawings of the present application, the terms "first", "second", and so on are intended to distinguish different objects but do not describe a specific order or primary and secondary relation.

In the descriptions of the present application, it should be noted that unless otherwise explicitly specified or defined, the terms such as "mount", "connect", "connection", and "attach" should be understood in a broad sense. For example, the connection may be a fixed connection, a detachable connection, or an integral connection. Alternatively, the connection may be a direct connection, an indirect connection through an intermediary, or internal communication between two components. A person of ordinary skill in the art may understand specific meanings of the terms in the present application according to specific situations.

In the descriptions of the embodiments of the present application, the term "and/or" is merely an association to describe associated objects. It may mean that there are three relationships, such as A and/or B, indicating that A exists alone, A and B exist at the same time, and B exists alone. In addition, the character "/" in this specification usually indicates an "or" relationship between the associated objects.

A signal sampling circuit in the related technology needs to have a function of high insulation and voltage resistance. A highly-insulated and voltage-resistant electronic device has high costs. Consequently, the signal sampling circuit in the related technology has a problem of high costs.

Embodiments of the present application provide a signal sampling circuit, a battery management system, a battery system, and a power consuming apparatus. The following describes the signal sampling circuit, the battery management system, the battery system, and the power consuming apparatus in the embodiments of the present application in detail with reference to the accompanying drawings.

The following first describes a signal sampling circuit provided in an embodiment of the present application.

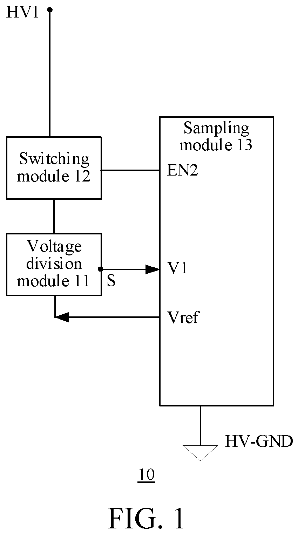

As shown in FIG. 1, a signal sampling circuit 10 may include a voltage division module 11, a switching module 12, and a sampling module 13.

The voltage division module 11 and the switching module 12 may be connected in series between a to-be-tested point HV1 and a reference signal end Vref of the sampling module 13. A control end of the switching module 12 may be connected to an enable signal end EN2 of the sampling module 13. The sampling module 13 may be connected to a first reference ground HV-GND.

By way of example, the to-be-tested point HV1 may be connected to a positive electrode of a to-be-tested battery pack BAT.

By way of example, the first reference ground HV-GND may be a negative electrode of the to-be-tested battery pack. To be specific, the first reference ground HV-GND may be a high-voltage ground.

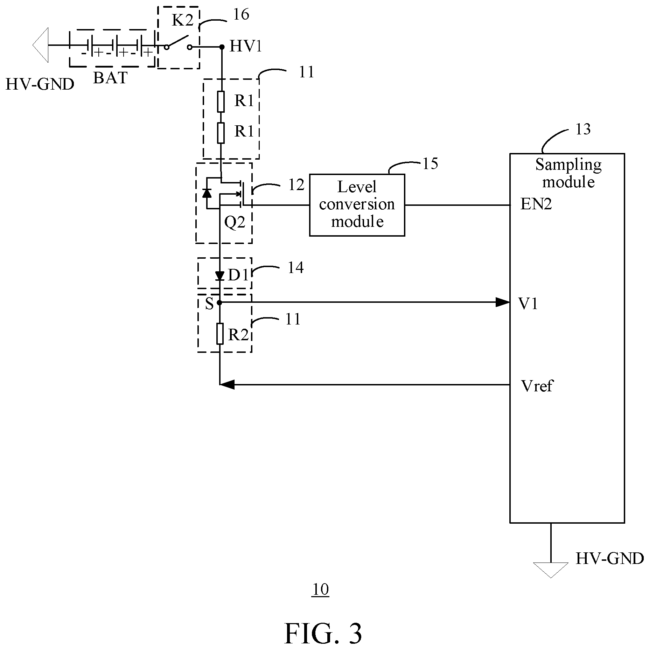

By way of example, the switching module 12 may include a photo-metal-oxide-semiconductor field-effect transistor (MOSFET), a MOS transistor, a relay, and the like. As shown in FIG. 3 to FIG. 9, the transistor may be an N-type MOS transistor Q2.

By way of example, the sampling module 13 may include a sampling chip. The sampling chip may be configured to acquire a sampling signal of a sampling point S and control the switching module 12 to be turned on or off. The sampling chip may include an analog to digital converter (ADC). The ADC may be configured to convert an acquired sampling signal from an analog signal to a data signal.

By way of example, the first reference ground HV-GND may be used as the reference signal end Vref. To be specific, a signal value of the first reference ground HV-GND may be equal to a signal value of the reference signal end Vref. The control end of the switching module 12 may be connected to an enable signal end EN2 of the sampling module 13, so that a control signal of the enable signal end EN2 may control the switching module 12 to be turned on or off. By way of example, the control signal may include an enable signal and a non-enable signal. The switching module 12 may be turned on when the enable signal end EN2 outputs the enable signal, or may be turned off when the enable signal end EN2 outputs the non-enable signal. To be specific, the enable signal may be a signal enabling the switching module 12 to be turned on, and the non-enable signal may be a signal enabling the switching module 12 to be turned off. For example, in a case that the switching module 12 includes a P-type MOS transistor or an NPN triode, the enable signal may be a low-level signal, and the non-enable signal may be a high-level signal. For another example, in a case that the switching module 12 includes an N-type MOS transistor or a PNP triode, the enable signal may be a high-level signal, and the non-enable signal may be a low-level signal.

A sampling point S may be provided in the voltage division module 11. The sampling module 13 may be configured to acquire a sampling signal of the sampling point S.

By way of example, the sampling signal may be a voltage value of the sampling point S.

In this embodiment of the present application, the voltage division module and the switching module are connected in series between the to-be-tested point and the reference signal end of the sampling module. The control end of the switching module is connected to the enable signal end of the sampling module. The sampling module is connected to the first reference ground. In a case that the to-be-tested point is a high-voltage to-be-tested point, the first reference ground may be a high-voltage ground, and the sampling module is connected to the high-voltage ground. Therefore, the sampling module is at a high-voltage side, so that the control end and a controlled end of the switching module are both located at the high-voltage side. Therefore, compared with a highly insulated and voltage-resistant device, the control end and the controlled end of the switching module help reduce costs of the signal sampling circuit.

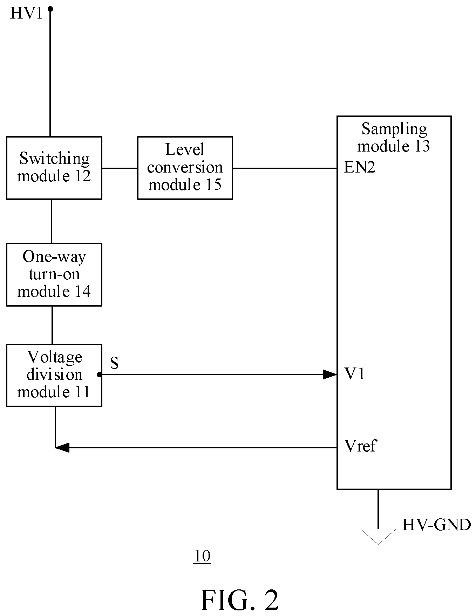

In some optional implementations, as shown in FIG. 2, the signal sampling circuit 10 may further include a one-way turn-on module 14. The one-way turn-on module 14, the switching module 12, and the voltage division module 11 may be connected in series between the to-be-tested point HV1 and a signal acquisition end V1 of the sampling module 13. The one-way turn-on module 14 may be configured to control a current to flow from the to-be-tested point HV1 to the sampling module 13. In this way, the one-way turn-on module 14 connected in series to the switching module 12 and the voltage division module 11 is provided to control the current to flow from the to-be-tested point HV1 to the sampling module 13, thereby reducing a risk of a potential loop in the signal sampling circuit when the switching module 12 is turned off.

The signal acquisition end V1 of the sampling module 13 may be configured to acquire the sampling signal of the sampling point S.

Optionally, as shown in FIG. 3 to FIG. 6, the one-way turn-on module 14 may include a diode D1. The diode D1 is provided in the one-way turn-on module 14 to control the current to flow from the to-be-tested point HV1 to the sampling module 13, thereby reducing a risk of a potential loop in the signal sampling circuit 10.

In some optional implementations, as shown in FIG. 3 to FIG. 6, the voltage division module 11 may include a first resistor R1 and a second resistor R2. The first resistor R1 and the second resistor R2 may be connected in series. The sampling point S may be provided between the first resistor R1 and the second resistor R2. In this way, the first resistor R1 and the second resistor R2 connected in series to the first resistor R1 are provided, and the sampling point S is provided between the first resistor R1 and the second resistor R2. Thus, the voltage value of the to-be-tested point HV1 may be calculated according to the sampling signal acquired by the sampling module 13 at the sampling point S and voltage division resistance of the second resistor R2.

It may be understood that, in FIG. 3 to FIG. 6, an example in which the signal sampling circuit includes two first resistors R1 is used for description. During specific implementation, a quantity of the first resistor R1 may be set according to an actual situation, and is not limited herein. For example, the quantity of the first resistor R1 may be 1, 3, 4, etc. The quantity of the first resistor R1 and the magnitude of a resistance value may be determined according to a voltage of the to-be-tested point HV1.

The second resistor R2 may be a sampling resistor.

As an example, as shown in FIG. 3, the diode D1 may be connected between the switching module 12 and the second resistor R2.

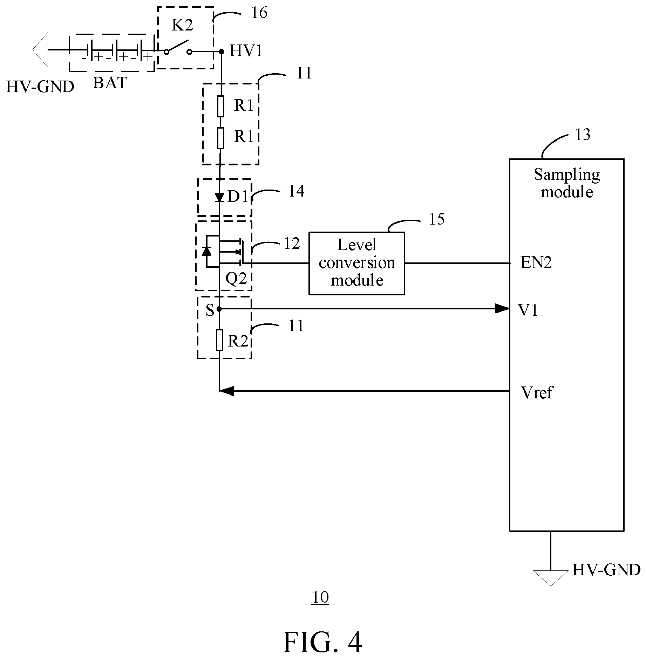

As another example, as shown in FIG. 4, the diode D1 may be connected between the switching module 12 and the first resistor R1.

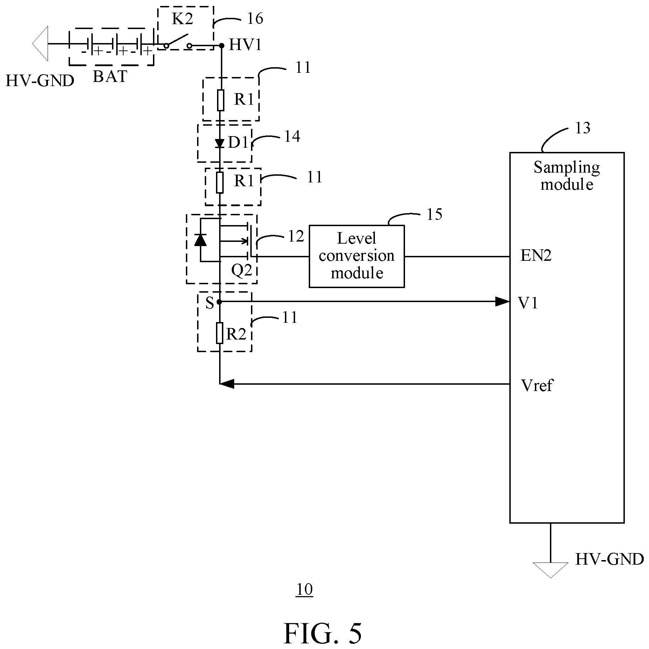

As still another example, as shown in FIG. 5, the diode D1 may be connected between two first resistors R1.

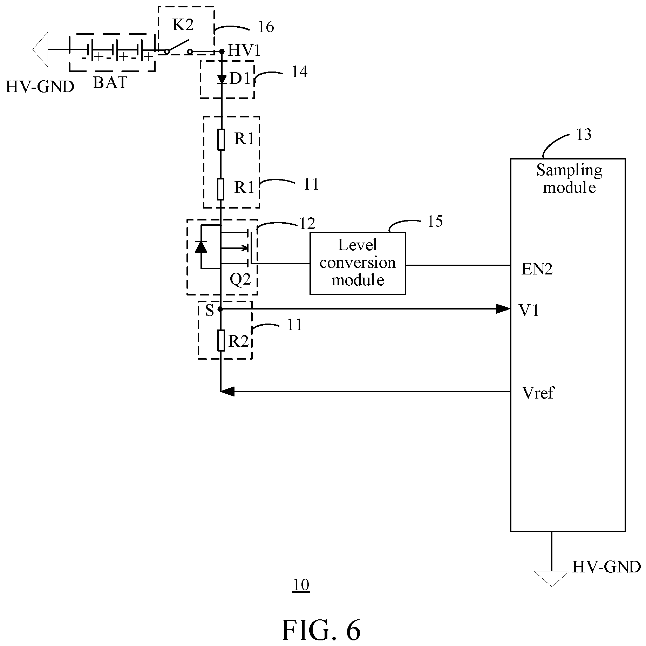

As still another example, as shown in FIG. 6, the diode D1 may be connected between the to-be-tested point HV1 and the first resistor R1.

It should be noted that, in this embodiment of the present application, a positive electrode of the diode D1 is electrically connected to the to-be-tested point HV1, and a negative electrode of the diode D1 is electrically connected to the reference signal end Vref.

In some optional implementations, as shown in FIG. 2 to FIG. 6, the signal sampling circuit 10 may further include a level conversion module 15. The level conversion module 15 may be connected between the enable signal end EN2 and the control end of the switching module 12. The level conversion module 15 may be configured to perform level conversion on a control signal of the enable signal end EN2, and may provide a level-converted control signal to the control end of the switching module 12. In this way, the level conversion module 15 connected between the enable signal end EN2 and the control end of the switching module 12 is provided. In a case that the control signal of the sampling module 13 does not satisfy a start condition for driving the switching module 12 and is insufficient for driving the switching module 12, the level conversion module 15 provides the level-converted control signal to the switching module 12, helping drive the switching module 12 to be turned on or off.

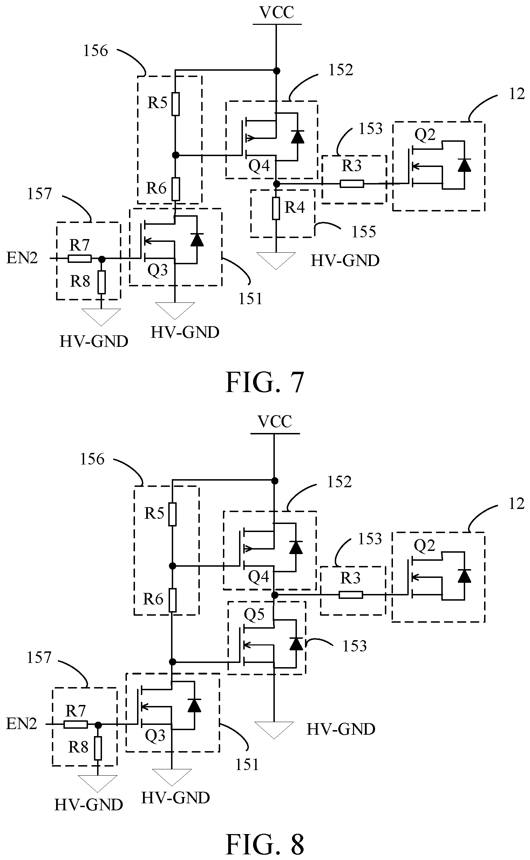

In some optional implementations, as shown in FIG. 7 and FIG. 8, the level conversion module 15 may include a first switching submodule 151 and a second switching submodule 152. A control end of the first switching submodule 151 may be connected to the enable signal end EN2. A first end of the first switching submodule 151 may be connected to the first reference ground HV-GND. A second end of the first switching submodule 151 may be connected to a control end of the second switching submodule 152. A first end of the second switching submodule 152 may be connected to a high-voltage power supply end VCC. A second end of the second switching submodule 152 may be connected to the first reference ground HV-GND and the control end of the switching module 12. The first switching submodule 151 may be configured to be turned on or off under the control of the control signal. The second switching submodule 152 may be configured to be turned on or off under the control of the first switching submodule 151, to perform level conversion on the control signal and provide the converted control signal to the control end of the switching module 12.

In this way, the first switching submodule 151 connected to the enable signal end EN2 and the second switching submodule 152 connected to the second end of the first switching submodule 151 are provided. The first switching submodule 151 may be turned on or off in a case that the enable signal end EN2 provides the control signal, and the second switching submodule 152 may be further controlled to be turned on or off, thereby performing level conversion on the control signal, to provide the level-converted control signal to the switching module 12 in a case that the control signal of the sampling module 13 does not satisfy the start condition for driving the switching module 12 and is insufficient for driving the switching module 12, helping drive the switching module 12 to be turned on or off.

Optionally, the first switching submodule 151 and the second switching submodule 152 may each include a transistor. In this way, the first switching submodule 151 and the second switching submodule 152 are each provided with the transistor. Then, by controlling the transistors to be turned on or off, the level-converted control signal is provided to the switching module 12 in a case that the control signal of the sampling module 13 does not satisfy the start condition for driving the switching module 12 and is insufficient for driving the switching module 12 to be turned off, helping drive the switching module 12 to be turned on or off.

By way of example, as shown in FIG. 7 and FIG. 8, the first switching submodule 151 may include an N-type MOS transistor Q3. Alternatively, the first switching submodule 151 may further include a PNP triode. The second switching submodule 152 may include a P-type MOS transistor Q4. Alternatively, the second switching submodule 152 may further include an NPN triode.

By way of example, the high-voltage power supply end VCC may be a power supply of approximately 10 V to 20 V with reference to the first reference ground HV-GND. The high-voltage power supply end VCC may be configured to drive a MOS transistor.

In some optional implementations, as shown in FIG. 8, the level conversion module 15 may further include a third switching submodule 153. A control end of the third switching submodule 153 may be connected to the second end of the first switching submodule 151. A first end of the third switching submodule 153 may be connected to the second end of the second switching submodule 152. A second end of the third switching submodule 153 may be connected to the first reference ground HV-GND. The third switching submodule 153 may be configured to be turned on or off under the control of the first switching submodule 151, to perform level conversion on the control signal and provide the converted control signal to the control end of the switching module 12.

In this way, the control end of the third switching submodule 153 is connected to the second end of the first switching submodule 151. The first switching submodule 151 may be turned off in a case that the enable signal end EN2 provides a non-enable signal, and the third switching submodule 153 may be further controlled to be turned off, thereby providing the level-converted non-enable signal to the switching module 12 in a case that the non-enable signal of the sampling module 13 does not satisfy the start condition for driving the switching module 12 and is insufficient for driving the switching module 12 to be turned off, helping drive the switching module 12 to be turned off.

Optionally, the third switching submodule 153 may include a transistor. In this way, the third switching submodule 153 is provided with the transistor. Then, by controlling the transistor to be turned on or off, the level-converted control signal is provided to the switching module 12 in a case that the control signal of the sampling module 13 does not satisfy the start condition for driving the switching module 12 and is insufficient for driving the switching module 12 to be turned off, helping drive the switching module 12 to be turned on or off.

By way of example, as shown in FIG. 8, the third switching submodule 153 may include an N-type MOS transistor Q4 or a PNP triode.

In some optional implementations, as shown in FIG. 7, the level conversion module 15 may further include a current limiting submodule 154. The current limiting submodule 154 may be connected between the control end of the switching module 12 and the second end of the second switching submodule 152.

In this way, the current limiting submodule 154 is provided in the level conversion module 15, to reduce the current between the control end of the switching module 12 and the second end of the second switching submodule 152, thereby helping protect the control end of the switching module 12 and the second end of the second switching submodule 152.

Optionally, the current limiting submodule 154 may include a third resistor R3. In this way, the current limiting submodule 154 is provided with the third resistor R3, to reduce the current between the control end of the switching module 12 and the second end of the second switching submodule 152, thereby helping protect the control end of the switching module 12 and the second end of the second switching submodule 152.

In some optional implementations, as shown in FIG. 7, the level conversion module 15 may further include a resetting submodule 155. The resetting submodule 155 may be connected between the control end of the switching module 12 and the first reference ground HV-GND. The resetting submodule 155 may be configured to reset the control end of the switching module 12. In this way, the resetting submodule 155 is provided in the level conversion module 15, facilitating resetting of the control end of the switching module 12.

Optionally, the resetting submodule 155 may include a fourth resistor R4. In this way, the resetting submodule 155 is provided with the fourth resistor R4, facilitating resetting of the control end of the switching module 12. In addition, after the N-type MOS transistor Q4 is turned off, the fourth resistor R4 may be configured to vent a capacitive charge between a gate and a source of the N-type MOS transistor Q2, helping turn off the N-type MOS transistor Q2.

In some optional implementations, as shown in FIG. 8, the level conversion module 15 may further include a current limiting submodule 154. The current limiting submodule 154 may be connected between the control end of the switching module 12 and the second end of the second switching submodule 152. In this way, the current limiting submodule 154 is provided in the level conversion module 15, to reduce the current between the control end of the switching module 12 and the second end of the second switching submodule 152, thereby helping protect the control end of the switching module 12 and the second end of the second switching submodule 152.

Optionally, the current limiting submodule 154 may include a third resistor R3. In this way, the current limiting submodule 154 is provided with the third resistor R3, to reduce the current between the control end of the switching module 12 and the second end of the second switching submodule 152, thereby helping protect the control end of the switching module 12 and the second end of the second switching submodule 152.

In some optional implementations, as shown in FIG. 7 and FIG. 8, the level conversion module 15 may further include a first voltage division submodule 156. The first voltage division submodule 156 may be connected between the high-voltage power supply end VCC and the second end of the first switching submodule 151, and a voltage division node of the first voltage division submodule 156 may be connected to the control end of the second switching submodule 152. In this way, the first voltage division submodule 156 is provided between the high-voltage power supply end VCC and the second end of the first switching submodule 151, and the voltage division node of the first voltage division submodule 156 is connected to the control end of the second switching submodule 152, helping reduce a voltage at the control end of the second switching submodule 152, thereby helping protect the second switching submodule 152.

In some optional implementations, the first voltage division submodule 156 may include a fifth resistor R5 and a sixth resistor R6. The fifth resistor R5 and the sixth resistor R6 may be connected in series. The voltage division node of the first voltage division submodule 156 may be provided between the fifth resistor R5 and the sixth resistor R6. In this way, the fifth resistor R5 and the sixth resistor R6 connected in series are provided in the first voltage division submodule 156, helping reduce the voltage at the control end of the second switching submodule 152 by means of voltage division between the fifth resistor R5 and the sixth resistor R6, thereby helping protect the second switching submodule 152. In addition, the magnitude of the voltage at the control end of the second switching submodule 152 may be flexibly controlled by controlling a resistance value between the fifth resistor R5 and the sixth resistor R6.

In some optional implementations, as shown in FIG. 7 and FIG. 8, the level conversion module 15 may further include a second voltage division submodule 157. The second voltage division submodule 157 may be connected to the enable signal end EN2 and the first reference ground HV-GND, and a voltage division node of the second voltage division submodule 157 may be connected to the control end of the first switching submodule 151. In this way, the second voltage division submodule 157 is provided between the enable signal end EN2 and the first reference ground HV-GND, and the voltage division node of the second voltage division submodule 157 is connected to the control end of the first switching submodule 151, helping reduce a voltage at the control end of the first switching submodule 151, thereby helping protect the first switching submodule 151.

In some optional implementations, the second voltage division submodule 157 may include a seventh resistor R7 and an eighth resistor R8. The seventh resistor R7 and the eighth resistor R8 may be connected in series. The voltage division node of the second voltage division submodule 157 may be provided between the seventh resistor R7 and the eighth resistor R8. In this way, the seventh resistor R7 and the eighth resistor R8 connected in series are provided in the second voltage division submodule 157, helping reduce the voltage at the control end of the first switching submodule 151 by means of voltage division between the seventh resistor R7 and the eighth resistor R8, thereby helping protect the first switching submodule 151. In addition, the magnitude of the voltage at the control end of the first switching submodule 151 may be flexibly controlled by controlling a resistance value between the seventh resistor R7 and the eighth resistor R8.

As an example, as shown in FIG. 7, in a case that the enable signal end EN2 outputs a high-level signal, the N-type MOS transistor Q3 is turned on. Then, when the control end of the P-type MOS transistor Q4 is a low-level signal, the P-type MOS transistor Q4 is turned on. When the control end of the N-type MOS transistor Q2 is a high-level signal, the N-type MOS transistor Q2 is turned on. In a case that the enable signal end EN2 outputs a low-level signal, the N-type MOS transistor Q3 is turned off. Then, when the control end of the P-type MOS transistor Q4 is a high-level signal, the P-type MOS transistor Q4 is turned off. When the control end of the N-type MOS transistor Q2 is a low-level signal, the N-type MOS transistor Q2 is turned off.

As another example, as shown in FIG. 8, in a case that the enable signal end EN2 outputs a high-level signal, the N-type MOS transistor Q3 is turned on. Then, when the control end of the P-type MOS transistor Q4 is a low-level signal, the P-type MOS transistor Q4 is turned on. When the control end of the N-type MOS transistor Q5 is a low-level signal, the N-type MOS transistor Q5 is turned off. When the control end of the N-type MOS transistor Q2 is a high-level signal, the N-type MOS transistor Q2 is turned on. In a case that the enable signal end EN2 outputs a low-level signal, the N-type MOS transistor Q3 is turned off. Then, when the control end of the P-type MOS transistor Q4 is a high-level signal, the P-type MOS transistor Q4 is turned off. When the control end of the N-type MOS transistor Q5 is a high-level signal, the N-type MOS transistor Q5 is turned on. When the control end of the N-type MOS transistor Q2 is a low-level signal, the N-type MOS transistor Q2 is turned off.

Optionally, as shown in FIG. 3 to FIG. 6, the signal sampling circuit 10 may further include a positive switching module 16. The positive switching module 16 may be connected between the positive electrode of the to-be-tested battery pack BAT and the to-be-tested point HV1.

By way of example, the positive switching module 16 may include a switch K2. The switch K2 may include a relay.

Based on a same inventive concept, an embodiment of the present application further provides a battery management system.

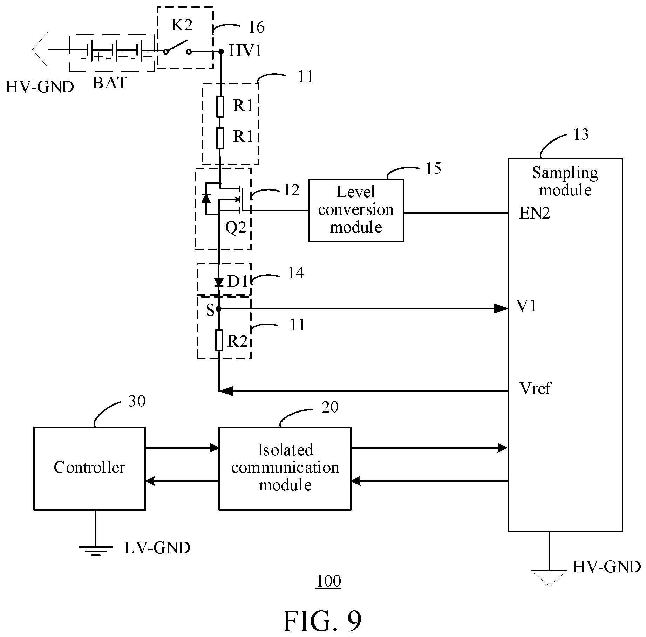

As shown in FIG. 9, a battery management system 100 according to an embodiment of the present application may include:
a controller 30;
an isolated communication module 20;
and a signal sampling circuit 10 in any of the foregoing embodiments. A sampling module 13 in the signal sampling circuit 10 is connected to the controller 30 by using the isolated communication module 20.

The controller 30 may be configured to:
send a sampling instruction to the sampling module 13 by using the isolated communication module 20, where the sampling instruction is configured for instructing the sampling module 13 to acquire a sampling signal and transmitting the sampling signal to the controller 30 by using the isolated communication module 20; and
receive the sampling signal.

In this embodiment of the present application, the controller 30 sends the sampling instruction to the sampling module 13 by using the isolated communication module 20, so that the sampling module 13 acquires the sampling signal, transmits the sampling signal to the controller 30 by using the isolated communication module 20, and receives the sampling signal, thereby helping calculate the voltage of a to-be-tested point HV1 by the controller 30 according to the sampling signal.

By way of example, the controller 30 may include a microcontroller unit (MCU). The isolated communication module 20 may include an isolated communication chip. The isolated communication module 20 may send the sampling instruction to the sampling module 13 by using a serial peripheral interface (SPI), an inter-integrated circuit (I2C), a universal asynchronous receiver/transmitter (Uart), a daisy chain, or the like.

By way of example, the controller 30 may be connected to a second reference ground LV-GND. The second reference ground LV-GND may be a ground. To be specific, the second reference ground LV-GND may be a low-voltage ground.

By way of example, there are two first resistors R1, a voltage U of the to-be-tested point HV1 may satisfy Formula (1). $U = \left(v1-vref\right) * \left(2r1+r2\right) / r 2$ Formula (1)
where v1 represents a sampling voltage of a sampling point S; vref represents a voltage at a reference signal end Vref in the sampling module 13; r1 represents a resistance value of the first resistor R1; and r2 represents a resistance value of a second resistor R2.

It may be understood that values of v1, vref, r1, and r2 are all known, and U may be calculated by substituting the values of v1, vref, r1, and r2 into Formula (1).

It should be noted that, in Formula (1), there are two first resistors R1. If the quantity of the first resistors R1 is N (N is a positive integer), "2r1" in Formula (1) is "N×r1".

In some optional implementations, as shown in FIG. 9, the sampling module 13 further includes a one-way turn-on module 14. The one-way turn-on module 14 includes a diode D1. The controller 30 is further configured to:
obtain a voltage drop value of the diode D1 at a target temperature and an initial voltage value of a to-be-tested point HV1 at the target temperature, where the initial voltage value is obtained through calculation according to the sampling signal; and
calibrate the initial voltage value by using the voltage drop value.

In this way, the controller 30 obtains the voltage drop value of the diode D1 at the target temperature and the initial voltage value of the to-be-tested point HV1 at the target temperature, and then may calibrate the initial voltage value by using the voltage drop value, to improve a problem that an impact of temperature on voltage drop of the diode D1 causes an error in the determined voltage of the to-be-tested point HV1, thereby improving accuracy of the voltage of the to-be-tested point HV1.

The calibrating the initial voltage value by using the voltage drop value may include: using a sum of the initial voltage value and the voltage drop value as a calibrated initial voltage value.

By way of example, the target temperature includes T1, T2, and T3. The voltage drop value of the diode D1 at T1 is D1, the voltage drop value of the diode D1 at T2 is D2, and the voltage drop value of the diode D1 at T3 is D3. The initial voltage value of the to-be-tested point HV1 at T1 is U1, the initial voltage value of the to-be-tested point HV1 at T2 is U2, and the initial voltage value of the to-be-tested point HV1 at T3 is U3. The calibrated initial voltage value corresponding to the to-be-tested point HV1 at T1 is U1'=U1+D1, the calibrated initial voltage value corresponding to the to-be-tested point HV1 at T2 is U2'=U2+D2, and the calibrated initial voltage value corresponding to the to-be-tested point HV1 at T3 is U3'=U3+D3.

A specific value and a quantity of the target temperature may be set according to an actual situation. This is not limited herein. For example, the specific value of the target temperature may be 20 degrees Celsius, 30 degrees Celsius, or the like. The quantity of the target temperature may be 1, 2, etc.

It may be understood that the battery management system has beneficial effects of the signal sampling circuit provided in an embodiment of the present application. For details, refer to specific descriptions of the signal sampling circuit in the foregoing embodiments. Details are not described herein again in this embodiment.

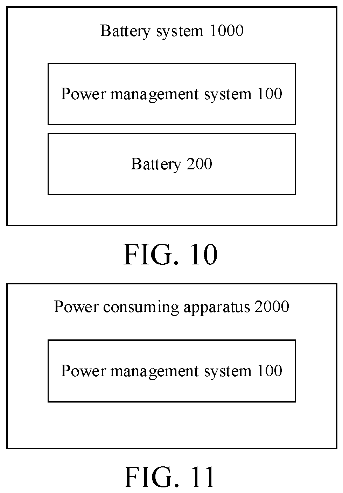

Based on a same inventive concept, an embodiment of the present application further provides a battery system. As shown in FIG. 10, a battery system 1000 may include a battery 200 and a battery management system 100. The battery management system 100 may include the signal sampling circuit in any one of the foregoing embodiments. It may be understood that the battery system has beneficial effects of the signal sampling circuit provided in an embodiment of the present application. For details, refer to specific descriptions of the signal sampling circuit in the foregoing embodiments. Details are not described herein again in this embodiment.

Based on a same inventive concept, an embodiment of the present application further provides a power consuming apparatus. As shown in FIG. 11, a power consuming apparatus 2000 may include a battery management system 100. The battery management system 100 may include the signal sampling circuit in any one of the foregoing embodiments. It may be understood that the power consuming apparatus has beneficial effects of the signal sampling circuit provided in an embodiment of the present application. For details, refer to specific descriptions of the signal sampling circuit in the foregoing embodiments. Details are not described herein again in this embodiment.

It should be noted that in the embodiments shown in the foregoing figures, the resistor is represented as an independent resistor. In another embodiment, the resistor may alternatively be an integration of series, parallel, or series-parallel resistors. Specific parameters of the components may be set according to actual requirements. This is not limited in the present application.

It should be noted that the embodiments in the present application and the features in the embodiments may be combined with each other without causing any conflict.

Although the present application has been described with reference to the preferred embodiments, various improvements may be made and components therein may be replaced with equivalents without departing from the scope of the present application. Especially, as long as there is no structural conflict, the various technical features mentioned in each embodiment may be combined in any way. The present application is not limited to the specific embodiments disclosed herein, but includes all technical solutions falling within the scope of the claims.

## Claims

1. A signal sampling circuit, comprising a voltage division module, a switching module, and a sampling module, wherein
the voltage division module and the switching module are connected in series between a to-be-tested point and a reference signal end of the sampling module, a control end of the switching module is connected to an enable signal end of the sampling module, and the sampling module is connected to a first reference ground; and
a sampling point is provided in the voltage division module, and the sampling module is configured to acquire a sampling signal of the sampling point.

2. The signal sampling circuit according to claim 1, further comprising a one-way turn-on module, wherein the one-way turn-on module, the switching module, and the voltage division module are connected in series between the to-be-tested point and a signal acquisition end of the sampling module, and the one-way turn-on module is configured to control a current to flow from the to-be-tested point to the sampling module.

3. The signal sampling circuit according to claim 1 or 2, wherein the voltage division module comprises a first resistor and a second resistor, the first resistor and the second resistor are connected in series, and the sampling point is provided between the first resistor and the second resistor.

4. The signal sampling circuit according to any one of claims 1 to 3, further comprising a level conversion module, wherein the level conversion module is connected between the enable signal end and the control end of the switching module, and the level conversion module is configured to perform level conversion on a control signal of the enable signal end, and provide a level-converted control signal to the control end of the switching module.

5. The signal sampling circuit according to claim 4, wherein the level conversion module comprises a first switching submodule and a second switching submodule, a control end of the first switching submodule is connected to the enable signal end, a first end of the first switching submodule is connected to the first reference ground, a second end of the first switching submodule is connected to a control end of the second switching submodule, a first end of the second switching submodule is connected to a high-voltage power supply end, and a second end of the second switching submodule is connected to the first reference ground and the control end of the switching module; and
the first switching submodule is configured to be turned on or off under the control of the control signal, and the second switching submodule is configured to be turned on or off under the control of the first switching submodule, to perform level conversion on the control signal and provide the converted control signal to the control end of the switching module.

6. The signal sampling circuit according to claim 5, wherein the level conversion module further comprises a third switching submodule, a control end of the third switching submodule is connected to the second end of the first switching submodule, a first end of the third switching submodule is connected to the second end of the second switching submodule, a second end of the third switching submodule is connected to the first reference ground, and the third switching submodule is configured to be turned on or off under the control of the first switching submodule, to perform level conversion on the control signal and provide the converted control signal to the control end of the switching module.

7. The signal sampling circuit according to claim 5, wherein the level conversion module further comprises a current limiting submodule, and the current limiting submodule is connected between the control end of the switching module and the second end of the second switching submodule;
and/or, the level conversion module further comprises a resetting submodule, the resetting submodule is connected between the control end of the switching module and the first reference ground, and the resetting submodule is configured to reset the control end of the switching module.

8. The signal sampling circuit according to claim 7, wherein the current limiting submodule comprises a third resistor;
and/or, the resetting submodule comprises a fourth resistor.

9. The signal sampling circuit according to claim 6, wherein the level conversion module further comprises a current limiting submodule, and the current limiting submodule is connected to the control end of the switching module and the second end of the second switching submodule.

10. The signal sampling circuit according to claim 9, wherein the current limiting submodule comprises a third resistor.

11. The signal sampling circuit according to claim 6 or 9 or 10, wherein the first switching submodule, the second switching submodule, and the third switching submodule each comprise a transistor.

12. The signal sampling circuit according to any one of claims 5 to 10, wherein the level conversion module further comprises a first voltage division submodule, the first voltage division submodule is connected between the high-voltage power supply end and the second end of the first switching submodule, and a voltage division node of the first voltage division submodule is connected to the control end of the second switching submodule;
and/or, the level conversion module further comprises a second voltage division submodule, the second voltage division submodule is connected to the enable signal end and the first reference ground, and a voltage division node of the second voltage division submodule is connected to the control end of the first switching submodule.

13. The signal sampling circuit according to claim 12, wherein the first voltage division submodule comprises a fifth resistor and a sixth resistor, the fifth resistor and the sixth resistor are connected in series, and the voltage division node of the first voltage division submodule is provided between the fifth resistor and the sixth resistor;
and/or, the second voltage division submodule includes a seventh resistor and an eighth resistor, the seventh resistor and the eighth resistor are connected in series, and the voltage division node of the second voltage division submodule is provided between the seventh resistor and the eighth resistor.

14. A battery management system, comprising:
a controller;
an isolated communication module;
and a signal sampling circuit according to any one of claims 1 to 13, wherein a sampling module in the signal sampling circuit is connected to the controller by using the isolated communication module; and
the controller is configured to:
send a sampling instruction to the sampling module by using the isolated communication module, the sampling instruction being configured for instructing the sampling module to acquire a sampling signal and transmitting the sampling signal to the controller by using the isolated communication module; and
receive the sampling signal.

15. The battery management system according to claim 14, wherein the sampling module further comprises a one-way turn-on module, the one-way turn-on module comprises a diode, and the controller is further configured to:
obtain a voltage drop value of the diode at a target temperature and an initial voltage value of a to-be-tested point at the target temperature, the initial voltage value being obtained through calculation according to the sampling signal; and
calibrate the initial voltage value by using the voltage drop value.

16. A battery system, comprising a battery and a battery management system according to claim 14 or 15.

17. A power consuming apparatus, comprising a battery management system according to claim 14 or 15.
